# EUROPÄISCHE PATENTSCHRIFT

(11) **EP 4 070 161 B1**
(45) Veröffentlichungstag und Bekanntmachung des Hinweises auf die Patenterteilung: **03.01.2024**
(21) Anmeldenummer: 20807003.7
(22) Anmeldetag: 12.11.2020
(51) Int. Cl.: G03F 7/20, G02B 27/62, G02B 7/00

(54) **VERFAHREN ZUR MONTAGE EINES OPTISCHEN SYSTEMS**
METHOD FOR MOUNTING AN OPTICAL SYSTEM
PROCÉDÉ DE MONTAGE D'UN SYSTÈME OPTIQUE

(30) Priorität: 05.12.2019 DE 102019218925
(43) Veröffentlichungstag der Anmeldung: 12.10.2022
(73) Patentinhaber: Carl Zeiss SMT GmbH, 73447 Oberkochen (DE)
(72) Erfinder: DORN, Johann, 89233 Neu-Ulm (DE); FRITZSCHE, Steffen, 73432 Aalen (DE); GRIMM, Wolfgang, 73432 Aalen (DE); NIELAND, Peter, 73430 Aalen (DE)
(74) Vertreter: Horn Kleimann Waitzhofer Schmid-Dreyer Patent- und Rechtsanwälte PartG mbB
(86) Internationale Anmeldenummer: PCT/EP2020/081919
(87) Internationale Veröffentlichungsnummer: WO 2021/110379

(56) Entgegenhaltungen:
- DE-A1- 10 258 715
- DE-A1-102011 078 016
- DE-B3-102016 212 853

## Beschreibung

Die vorliegende Erfindung betrifft ein Verfahren zur Montage eines optischen Systems, ein Verfahren zum Betrieb eines optischen Systems, eine Datenverarbeitungsvorrichtung sowie ein Computerprogrammprodukt.

Die Mikrolithographie wird zur Herstellung mikrostrukturierter Bauelemente, wie beispielsweise integrierter Schaltkreise, angewendet. Der Mikrolithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat, beispielsweise einen Siliziumwafer, projiziert, um die Maskenstruktur auf die lichtempfindliche Beschichtung des Substrats zu übertragen.

Beim Aufbau von optischen Systemen wie dem Projektionssystem (auch als Projektionsobjektiv oder projection optics box - POB - bezeichnet) ist eine exakte Positionierung von optischen Oberflächen und anderen Funktionsflächen (z.B. an Blenden oder Endstopps) im Mikrometerbereich in allen sechs Freiheitsgraden notwendig. Dabei ist es oftmals nicht möglich, die Position der Funktionsflächen im eingebauten Zustand direkt zu messen.

Eine andere Schwierigkeit ergibt sich daraus, dass die geforderte Einbaugenauigkeit der Funktionsflächen erheblich geringer als die Fertigungsgenauigkeit der Bauteile bzw. Einzelteile ist oder dass es ein großer Aufwand wäre, die Funktionsflächen sehr genau zu den Kontakt- und Referenzflächen zu fertigen. Deshalb ist es Praxis, abstimmbare Abstandshalter bzw. Zwischenstücke (Engl.: Spacer) an den Schnittstellen der Einzelteile, die diese zueinander aufweisen, wie etwa Kontaktflächen oder Verschraubungen, einzufügen. Falls der zuerst eingebaute Satz Zwischenstücke nicht zur geforderten Positionsgenauigkeit der Funktionsfläche führt, wird dieser Satz durch einen neuen Satz Zwischenstücken ersetzt oder individuell angepasst, insbesondere geschliffen oder poliert. In der Regel werden die sechs Freiheitsgrade nacheinander justiert, was zu mehreren Justageschleifen führt. Der Umstand, dass die Wirkrichtungen der Zwischenstücke oft nicht zueinander orthogonal, d.h., voneinander nicht entkoppelt sind, führt zu zusätzlichen Justageschleifen. Dies erhöht die zur Fertigung des optischen Systems benötigte Zeit und somit die Kosten. Dies insbesondere dann, wenn Zwischenstücke individuell angepasst, d.h. auf ein bestimmtes Maß, gefertigt werden müssen.

DE102016212853 B3 offenbart ein Verfahren zum Justieren einer optischen Einrichtung.

Vor diesem Hintergrund besteht eine Aufgabe der vorliegenden Erfindung darin, einen verbesserten Ansatz bereitzustellen.

Demgemäß wird gemäß einem ersten Aspekt vorgeschlagen ein Verfahren zur Montage eines optischen Systems, insbesondere Lithographieanlage, mit den Schritten:
a) Vermessen von Einzelteilen K1 - KN des optischen Systems zur Bereitstellung von Messdaten, mit N > 1,
b) Virtualisieren der Einzelteile K1 - KN mithilfe der bereitgestellten Messdaten und Erzeugen eines Ist-Montage-Modells aus den virtualisierten Einzelteilen K1 - KN, wobei das Ist-Montagemodell virtuelle Ist-Positionen der virtualisierten Einzelteile K1 - KN in einem virtuell montierten Zustand enthält,
c) Ermitteln einer Korrekturmaßnahme in Abhängigkeit des Ist-Montage-Modells und eines Soll-Montage-Modells, wobei das Soll-Montagemodell virtuelle Soll-Positionen eines oder mehrerer der virtualisierten Einzelteile K1 - KN in dem virtuell montierten Zustand enthält, und
d) Montieren der Einzelteile K1 - KN zu dem optischen System unter Anwendung der Korrekturmaßnahme.

Dadurch werden die einleitend beschriebenen Justageschleifen weitestgehend vermieden. Außerdem kann eine Korrektur an nur einer oder einigen wenigen Stellen vorgenommen werden, die dann zur gewünschten Soll-Position der Funktionsfläche (an einem der Einzelteile K1-KN) führt. Es müssen also nicht alle Einzelteile hochgenau gefertigt werden. Außerdem kann so auch die Lage einer nach der Montage nicht mehr messtechnisch erreichbaren Funktionsfläche mit hoher Genauigkeit eingestellt werden. Insbesondere lassen sich somit die Toleranzen der beteiligten Komponenten bzw. Einzelteile und Montageprozesse relaxieren, und dadurch Entwicklungsaufwände (z.B. Entwicklung präziser Werkzeuge) und Produktionskosten (Durchlaufzeit, Ausschuss, Einzelteilkosten) reduzieren.

Das optische System kann eine Lithographieanlage oder ein Teil davon, wie etwa ein Beleuchtungssystem oder Projektionssystem, sein.

Das Vermessen gemäß Schritt a) kann ein Vermessen insbesondere mechanischer (insbesondere Maße, Dimensionen, Toleranzen etc.), optischer (Reflektivität usw.) und/oder thermischer Eigenschaften eines jeweiligen Einzelteils aufweisen. Das Vermessen kann insbesondere mechanisch oder optisch erfolgen.

"Daten" meint hier elektronische Daten.

"Virtualisieren der Einzelteile K1 - KN" meint das Erzeugen von Daten, welche die Einzelteile K1 - KN beschreiben. Diese Daten können die Einzelteile K1 - KN mittels Punkten, Flächen, Koordinatensystemen oder dreidimensionalen Körpern beschreiben.

"Erzeugen eines Ist-Montage-Modells" meint, dass zu den die Einzelteile K1 - KN beschreibenden elektronischen Daten weitere Daten hinzugefügt werden, welche die Beziehungen der virtualisierten Einzelteile K1 - KN zueinander beschreiben, sodass sich virtuelle Ist-Positionen der virtualisierten Einzelteile K1 - KN in einem virtuell montierten Zustand dieser ergeben. Diese weiteren Daten können Aufbaudaten sein, die aus einem CAD (Engl.: Computer Aided Design)-Modell stammen. Das CAD-Modell kann geometrische, mechanische, optische und/oder thermische Eigenschaften, Parameter und/oder Schnittstellen (zwischen den Einzelteilen) umfassen.

Das Ist-Montage-Modell wird beispielsweise durch geometrisches Aneinanderreihen mehrerer der virtualisierten Einzelteile K1 - KN erzeugt.

In Ausführungsformen enthält das Ist-Montagemodell beispielsweise zusätzlich zu den virtuellen Ist-Positionen der virtualisierten Einzelteile K1 - KN in einem virtuell montierten Zustand auch mechanische Beziehungen der virtualisierten Einzelteile K1 - KN zueinander.

Das Soll-Montage-Modell kann Daten aufweisen, welche aus dem CAD-Modell stammen oder aus diesem abgeleitet sind. Das Soll-Montage-Modell enthält zumindest die (idealen bzw. angestrebten) Positionen der ein oder mehreren Funktionsflächen von einem oder von mehreren Einzelteilen, kann aber auch Positionen anderer Einzelteile (ohne Funktionsflächen) beschreiben.

Soweit vorliegend von einer Ist- und/oder Soll-Position eines der oder mehrerer der virtualisierten Einzelteile K1 - KN gesprochen wird, so meint dies die Ist- und/oder Soll-Position eines oder mehrerer Punkte, Flächen und/oder dreidimensionaler Körper (z.B. ein Tetraeder-Mesh) des einen oder der mehreren virtualisierten Einzelteile K1 - KN.

Die ermittelte Korrekturmaßnahme ist vorzugsweise derart ausgebildet, dass diese auf eine geometrische und/oder mechanische Beziehung von wenigstens zwei der Einzelteile K1 - KN zueinander wirkt. Das heißt, dass die Korrekturmaßnahme beispielsweise eine relative Position und/oder Ausrichtung der wenigstens zwei Einzelteile beeinflusst.

Das Montieren umfasst ein Verbinden, insbesondere Fügen, der Einzelteile K1 - KN, insbesondere durch Form-, Kraft,- und/oder Stoffschluss, aneinander. Unter "Verbinden" ist vorliegend ein formschlüssiges, kraftschlüssiges oder stoffschlüssiges Verbinden oder eine Kombination davon zu verstehen. Eine formschlüssige Verbindung entsteht durch das Ineinander- oder Hintergreifen von mindestens zwei Verbindungspartnern. Eine kraftschlüssige Verbindung, wie etwa das Schrauben, setzt eine Normal-Kraft auf die miteinander zu verbindenden Flächen voraus. Kraftschlüssige Verbindungen können durch Reibschluss verwirklicht werden. Die gegenseitige Verschiebung der Flächen ist verhindert, solange die durch die Haftreibung bewirkte Gegen-Kraft nicht überschritten wird. Eine kraftschlüssige Verbindung kann auch als ein magnetischer Kraftschluss vorliegen. Bei stoffschlüssigen Verbindungen werden die Verbindungspartner durch atomare oder molekulare Kräfte zusammengehalten. Stoffschlüssige Verbindungen sind nicht lösbare Verbindungen, die sich nur durch Zerstörung der Verbindungsmittel trennen lassen. Stoffschlüssig kann z.B. durch Kleben, Löten, Schweißen oder Vulkanisieren verbunden werden.

N ist eine ganze Zahl größer 1.

Gemäß einer Ausführungsform weist das Verfahren auf:
Erzeugen des Ist-Montage-Modells durch geometrisches Aneinanderreihen der virtualisierten Einzelteile K1 - KN, und
Ermitteln der Korrekturmaßnahme in Schritt c) in Abhängigkeit eines Vergleichs der virtuellen Ist-Position des virtualisierten Einzelteils KN mit der virtuellen Soll-Position des virtualisierten Einzelteils KN.

Dies beschreibt die sogenannten virtuellen Kontaktmontage. Gemäß einer Variante der virtuellen Kontaktmontage wird ermittelt, wo eine Funktionsfläche angeordnet sein wird, wenn alle Einzelteile gemäß ihren geometrischen Messdaten verbaut werden. Es können auch Vorhalte einbezogen werden, die zum Beispiel Formänderungen der Einzelteile berücksichtigen. Formänderungen können sich durch unterschiedliche Lagerungen und unterschiedliche Massen der Einzelteile oder Baugruppen ergeben. So wird zum Beispiel beim Aufbau eines Projektionsobjektivs zunächst ein Tragrahmen montiert, der nach und nach mit Modulen gefüllt wird und deshalb Laständerungen und somit Formänderungen erfährt.

Gemäß einer weiteren Ausführungsform weist das Verfahren auf:
Erzeugen des Ist-Montage-Modell durch Fixieren der virtualisierten Einzelteile K1 und KN an ihren Soll-Positionen aus dem Soll-Montage-Modell,
Geometrisches Aneinanderreihen der virtualisierten Einzelteile K2 - KN-1 an K1 und/oder KN,
Ermitteln der Korrekturmaßnahme in Schritt c) in Abhängigkeit von virtuellen Ist-Positionen von zumindest zwei virtualisierten Einzelteilen K2 - KN-1.

Dies beschreibt die virtuelle Soll-Punkt-Montage. Bei dieser ergeben sich vorteilhaft verbleibende Spalte direkt - und zwar zwischen denjenigen (zwei oder mehr) Einzelteilen (von den Einzelteilten K2 - KN), die sich am Ende des Aneinanderreihungsprozesses nicht berühren.

Gemäß einer weiteren Ausführungsform wird die Korrekturmaßnahme in Schritt d) auf das Einzelteil KN-1 oder auf einen Bereich, insbesondere Spalt, zwischen den Einzelteilen KN-1 und KN angewendet.

Vorteilhaft erfolgt die Korrektur benachbart zu dem Einzelteil KN (das insbesondere die Funktionsfläche aufweist). Es besteht eine erhöhte Wahrscheinlichkeit, dass sich Toleranzfehler bis zum Einzelteil KN-1 ausgeglichen haben.

Gemäß einer weiteren Ausführungsform weist das Einzelteil KN auf: ein optisches Element, insbesondere ein Spiegel, eine Linse, ein optisches Gitter und/oder eine Lambda-Platte, eine Blende, einen Sensor und/oder einen Endstopp.

Dies benennt Beispiele eines Einzelteils KN mit Funktionsflächen.

Alternativ kann es sich bei dem Einzelteil KN um eine mechanische Komponente, eine mechatronische Komponente, insbesondere ein Aktuator, und/oder ein Lager handeln.

Gemäß einer weiteren Ausführungsform weist das Einzelteil KN-1 auf: eine mechanische Komponente, eine mechatronische Komponente, insbesondere ein Aktuator, und/oder ein Lager.

Vorteilhaft erfolgt die Fehlerkorrektur an derartigen Komponenten, da sie - beispielsweise durch Justieren eines Arbeitsbereichs eines Aktuators - einfach möglich ist. "Mechanische Komponente" umfasst hier insbesondere eine mechanische Referenzfläche oder Passung, beispielsweise Passstift oder Passbohrung. "Lager" umfasst hier insbesondere ein mechanisches und/oder magnetisches Lager, wie etwa einen Gewichtskraftkompensator für optische Elemente.

Gemäß einer weiteren Ausführungsform weist die Korrekturmaßnahme auf: Einfügen eines Abstandshalters insbesondere zwischen zwei der Einzelteile K1 - KN, Einstellen eines Spiels eines Befestigungsmittels, das insbesondere zwei der Einzelteile K1 - KN aneinander befestigt, und/oder Einstellen eines Arbeitspunkts einer mechatronischen Komponente, insbesondere eines Aktuators als Bestandteil eines der Einzelteile K1 - KN.

Gemäß einer weiteren Ausführungsform wird die Korrekturmaßnahme in Schritt c) ermittelt in Abhängigkeit eines zur Verfügung stehenden Stellwegs des Aktuators.

Gemäß einer weiteren Ausführungsform ist N > 5 oder 10.

Gemäß einer weiteren Ausführungsform wird in Schritt c) ein Spalt zwischen zwei der Einzelteile K1 - KN ermittelt und in Schritt d) ein Abstandshalter in den Spalt eingefügt wird.

Der Abstandshalter ist vorzugsweise ein Zwischenstück, eine Unterlegscheibe usw. (Engl.: spacer, shim), insbesondere aus Metall oder Keramik. Alternativ oder zusätzlich kann der Abstandshalter hinsichtlich des von ihm definierten Abstands, insbesondere hinsichtlich seiner Dicke, verstellbar, z.B. in Form einer Einstellschraube oder zueinander verschieblicher Keile, vorgesehen sein. Der Abstandshalter kann in Ausführungsformen nach der Montage, also insbesondere nach Schritt d), wieder entfernt werden.

Gemäß einer weiteren Ausführungsform betrifft die Korrekturmaßnahme gemäß Schritt c) zumindest einen ersten und einen zweiten Freiheitsgrad.

Gemäß einer weiteren Ausführungsform wird die Korrekturmaßnahme in Schritt d) für den ersten Freiheitsgrad auf ein erstes der Einzelteile K1 - KN oder zwischen einem ersten Paar Einzelteile K1 - KN und für den zweiten Freiheitsgrad auf ein zweites der Einzelteile K1 - KN oder zwischen einem zweiten Paar Einzelteile K1 - KN angewendet.

Dadurch, dass die Korrekturmaßnahmen auf unterschiedliche Einzelteile aufgeteilt werden, kann diese einfacher ermittelt werden (eine wechselseitige Beeinflussung der Korrekturmaßnahmen wird vermieden oder reduziert).

Gemäß einer weiteren Ausführungsform weist das Verfahren auf:
Vermessen des montierten optischen Systems zur Bereitstellung von Montagemessdaten,
Ermitteln einer weiteren Korrekturmaßnahme in Abhängigkeit eines Vergleichs der Montagemessdaten und dem Soll-Montage-Modell, und
Ausrichten eines oder mehrerer der Einzelteile K1 - KN in Abhängigkeit der ermittelten weiteren Korrekturmaßnahme.

Hier erfolgt eine weitere Korrektur durch Vergleich des montierten optischen Systems mit dem Soll-Montage-Modell.

Gemäß einer weiteren Ausführungsform wird Ist-Montage-Modell mithilfe analytischer Geometrie, insbesondere homogener Koordinaten und/oder Eulerwinkeln, ermittelt.

Dies ist einfach durchführbar, insbesondere auf einer Rechnereinrichtung, wie einem Mikroprozessor.

Gemäß einem zweiten Aspekt wird vorgeschlagen ein Verfahren zum Betrieb eines optischen Systems, insbesondere Lithographieanlage, mit den Schritten:
a) Vermessen von Einzelteilen K1 - KN des optischen Systems zur Bereitstellung von Messdaten, mit N > 1,
b) Virtualisieren der Einzelteile K1 - KN mithilfe der bereitgestellten Messdaten und Erzeugen eines Ist-Montage-Modells aus den virtualisierten Einzelteilen K1 - KN, wobei das Ist-Montagemodell virtuelle Ist-Positionen der virtualisierten Einzelteile K1 - KN in einem virtuell montierten Zustand enthält,
c) Ermitteln einer Korrekturmaßnahme in Abhängigkeit des Ist-Montage-Modells und eines Soll-Montage-Modells, wobei das Soll-Montagemodell virtuelle Soll-Positionen eines oder mehrerer der virtualisierten Einzelteile K1 - KN in dem virtuell montierten Zustand enthält, und
d) Montieren der Einzelteile K1 - KN zu dem optischen System und Betreiben des optischen Systems unter Anwendung der Korrekturmaßnahme.

Das Betreiben des optischen Systems meint dessen Einsatz zu dem bestimmungsgemäßen Zweck. Insbesondere meint das Betreiben des optischen Systems das Durchführen von Belichtungsvorgängen mit diesem, etwa das Belichten von Wafern zur Fertigung von Mikrochips. Vorteilhaft wird hier die Korrektur der Fertigungsfehler (Toleranzen) insbesondere mithilfe einer entsprechenden Anpassung der Steuerung des optischen Systems erreicht. Beispielsweise kann ein Verfahrweg bzw. Arbeitspunkt eines Aktuators im Betrieb derart vorgesehen sein, dass die Korrektur erreicht wird.

Das Verfahren gemäß dem zweiten Aspekt kann mit dem des ersten Aspekts kombiniert werden, sodass Korrekturmaßnahmen bei der Montage und bei dem Betrieb zunächst ermittelt und dann in der Montage bzw. im Betrieb angewandt werden. Gemäß einem dritten Aspekt wird daher bereitgestellt:
Ein Verfahren zur Montage und/oder zum Betrieb eines optischen Systems, insbesondere Lithographieanlage, mit den Schritten:
a) Vermessen von Einzelteilen K1 - KN des optischen Systems zur Bereitstellung von Messdaten, mit N > 1,
b) Virtualisieren der Einzelteile K1 - KN mithilfe der bereitgestellten Messdaten und Erzeugen eines Ist-Montage-Modells aus den virtualisierten Einzelteilen K1 - KN, wobei das Ist-Montagemodell virtuelle Ist-Positionen der virtualisierten Einzelteile K1 - KN in einem virtuell montierten Zustand enthält,
c) Ermitteln einer Korrekturmaßnahme in Abhängigkeit des Ist-Montage-Modells und eines Soll-Montage-Modells, wobei das Soll-Montagemodell virtuelle Soll-Positionen eines oder mehrerer der virtualisierten Einzelteile K1 - KN in dem virtuell montierten Zustand enthält, und
d) Montieren der K1 - KN Einzelteile zu dem optischen System unter Anwendung der Korrekturmaßnahme und/oder Betreiben des optischen Systems unter Anwendung der Korrekturmaßnahme.

Gemäß einem vierten Aspekt wird vorgeschlagen eine Datenverarbeitungsvorrichtung, mit:
einer Virtualisier-Einheit zur Virtualisierung von Einzelteile K1 - KN eines optischen Systems mithilfe von bereitgestellten Messdaten und Erzeugung eines Ist-Montage-Modells aus den virtualisierten Einzelteilen K1 - KN, wobei das Ist-Montagemodell virtuelle Ist-Positionen der virtualisierten Einzelteile K1 - KN in einem virtuell montierten Zustand enthält, und
einer Ermittler-Einheit zur Ermittlung einer Korrekturmaßnahme zur Anwendung bei einer Montage des optischen Systems aus den Einzelteilten K1 - KN oder bei einem Betrieb des aus den Einzelteilten K1 - KN montierten optischen Systems in Abhängigkeit des Ist-Montage-Modells und eines Soll-Montage-Modells, wobei das Soll-Montagemodell virtuelle Soll-Positionen eines oder mehrerer der virtualisierten Einzelteile K1 - KN in dem virtuell montierten Zustand enthält.

Die jeweilige Einrichtung oder Einheit, zum Beispiel die Messeinrichtung, Rechnereinrichtung, Virtualisier-Einheit oder Ermittler-Einheit, kann hardwaretechnisch und/oder softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor ausgebildet sein. Bei einer softwaretechnischen Implementierung können die jeweilige Einrichtung bzw. Einheit als Computerprogrammprodukt als eine Funktion, als eine Routine, als Teil eines Programmcodes oder als ausführbares Objekt ausgebildet sein.

Gemäß einem fünften Aspekt wird vorgeschlagen ein Computerprogrammprodukt, welches auf zumindest einer programmgesteuerten Einrichtung die Durchführung der folgenden Schritte veranlasst:
Virtualisieren von Einzelteilen K1 - KN eines optischen Systems mithilfe von bereitgestellten Messdaten und Erzeugen eines Ist-Montage-Modells aus den virtualisierten Einzelteilen K1 - KN, wobei das Ist-Montagemodell virtuelle Ist-Positionen der virtualisierten Einzelteile K1 - KN in einem virtuell montierten Zustand enthält, und
Ermitteln einer Korrekturmaßnahme zur Anwendung bei einer Montage des optischen Systems aus den Einzelteilten K1 - KN oder bei einem Betrieb des aus den Einzelteilten K1 - KN montierten optischen Systems in Abhängigkeit des Ist-Montage-Modells und eines Soll-Montage-Modell, wobei das Soll-Montagemodell virtuelle Soll-Positionen eines oder mehrerer der virtualisierten Einzelteile K1 - KN in dem virtuell montierten Zustand enthält.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt erfolgen.

"Ein" ist vorliegend nicht zwingend als beschränkend auf genau ein Element zu verstehen. Vielmehr können auch mehrere Elemente, wie beispielsweise zwei, drei oder mehr, vorgesehen sein. Auch jedes andere hier verwendete Zählwort ist nicht dahingehend zu verstehen, dass eine Beschränkung auf genau die genannte Anzahl von Elementen gegeben ist. Vielmehr sind zahlenmäßige Abweichungen nach oben und nach unten möglich, soweit nichts Gegenteiliges angegeben ist. Die Bezeichnung der Verfahrensschritte mit a), b) usw. ist nicht einschränkend auf eine bestimmte Reihenfolge zu verstehen. Auch eine Umbenennung der Schritte, z.B. aus Schritt b) wird Schritt f), ist, insbesondere zum Zweck des Einfügens eines vorausgehenden oder nachfolgenden Schritts oder Zwischenschritts, möglich.

Die für das Verfahren gemäß dem ersten Aspekt beschriebenen Ausführungsformen und Merkmale gelten für das vorgeschlagene Verfahren gemäß dem zweiten und dritten Aspekt, die Datenverarbeitungsvorrichtung und das Computerprogrammprodukt entsprechend und umgekehrt.

Weitere mögliche Implementierungen der Erfindung umfassen auch nicht explizit genannte Kombinationen von zuvor oder im Folgenden bezüglich der Ausführungsbeispiele beschriebenen Merkmalen oder Ausführungsformen. Die Erfindung wird durch die Ansprüche definiert.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1A zeigt eine schematische Ansicht einer Ausführungsform einer EUV-Lithographieanlage;
Fig. 1B zeigt eine schematische Ansicht einer Ausführungsform einer DUV-Lithographieanlage;
Fig. 2 zeigt eine Datenverarbeitungsvorrichtung zur Verwendung in einem Verfahren zur Montage und zum Betrieb eines optischen Systems;
Fig. 3 zeigt eine Ausführungsform eines Kontakt-Montage-Modells;
Fig. 4 zeigt eine Ausführungsform eines Soll-Punkt-Montage-Modells;
Fig. 5 zeigt in einer Ausführungsform das Einsetzen von Abstandshaltern zur Korrektur verschiedener Freiheitsgrade bei einem optischen System;
Fig. 6 zeigt eine beispielhafte Verschiebung und Rotation von Einzelteilen unter Verwendung von homogenen Koordinaten; und
Fig. 7 zeigt ein Ablaufdiagram eines Verfahrens zur Montage und gegebenenfalls Betrieb eines optischen Systems gemäß einer Ausführungsform.

In den Figuren sind gleiche oder funktionsgleiche Elemente mit denselben Bezugszeichen versehen worden, soweit nichts Gegenteiliges angegeben ist. Ferner sollte beachtet werden, dass die Darstellungen in den Figuren nicht notwendigerweise maßstabsgerecht sind.

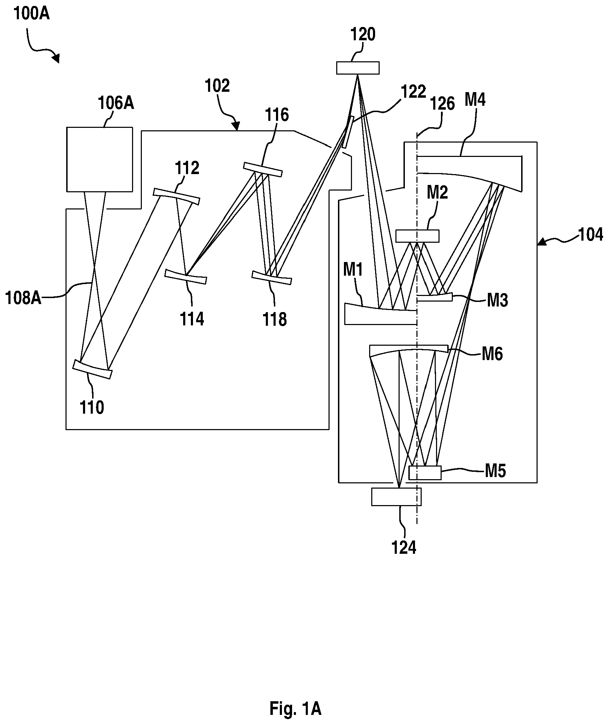

Fig. 1A zeigt eine schematische Ansicht einer EUV-Lithographieanlage 100A, welche ein Strahlformungs- und Beleuchtungssystem 102 und ein Projektionssystem 104 umfasst. Dabei steht EUV für "extremes Ultraviolett" (Engl.: extreme ultraviolet, EUV) und bezeichnet eine Wellenlänge des Arbeitslichts zwischen 0,1 nm und 30 nm. Das Strahlformungs- und Beleuchtungssystem 102 und das Projektionssystem 104 sind jeweils in einem nicht gezeigten Vakuum-Gehäuse vorgesehen, wobei jedes Vakuum-Gehäuse mit Hilfe einer nicht dargestellten Evakuierungsvorrichtung evakuiert wird. Die Vakuum-Gehäuse sind von einem nicht dargestellten Maschinenraum umgeben, in welchem Antriebsvorrichtungen zum mechanischen Verfahren beziehungsweise Einstellen von optischen Elementen vorgesehen sind. Ferner können auch elektrische Steuerungen und dergleichen in diesem Maschinenraum vorgesehen sein.

Die EUV-Lithographieanlage 100A weist eine EUV-Lichtquelle 106A auf. Als EUV-Lichtquelle 106A kann beispielsweise eine Plasmaquelle (oder ein Synchrotron) vorgesehen sein, welche Strahlung 108A im EUV-Bereich (extrem ultravioletter Bereich), also beispielsweise im Wellenlängenbereich von 5 nm bis 20 nm, aussendet. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlformungs- und Beleuchtungssystem 102 und im Projektionssystem 104 evakuiert sind.

Das in Fig. 1A dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf eine Photomaske (Engl.: reticle) 120 geleitet. Die Photomaske 120 ist ebenfalls als reflektives optisches Element ausgebildet und kann außerhalb der Systeme 102, 104 angeordnet sein. Weiter kann die EUV-Strahlung 108A mittels eines Spiegels 122 auf die Photomaske 120 gelenkt werden. Die Photomaske 120 weist eine Struktur auf, welche mittels des Projektionssystems 104 verkleinert auf einen Wafer 124 oder dergleichen abgebildet wird.

Das Projektionssystem 104 (auch als Projektionsobjektiv bezeichnet) weist sechs Spiegel M1 bis M6 zur Abbildung der Photomaske 120 auf den Wafer 124 auf. Dabei können einzelne Spiegel M1 bis M6 des Projektionssystems 104 symmetrisch zu einer optischen Achse 126 des Projektionssystems 104 angeordnet sein. Es sollte beachtet werden, dass die Anzahl der Spiegel M1 bis M6 der EUV-Lithographieanlage 100A nicht auf die dargestellte Anzahl beschränkt ist. Es können auch mehr oder weniger Spiegel M1 bis M6 vorgesehen sein. Des Weiteren sind die Spiegel M1 bis M6 in der Regel an ihrer Vorderseite zur Strahlformung gekrümmt.

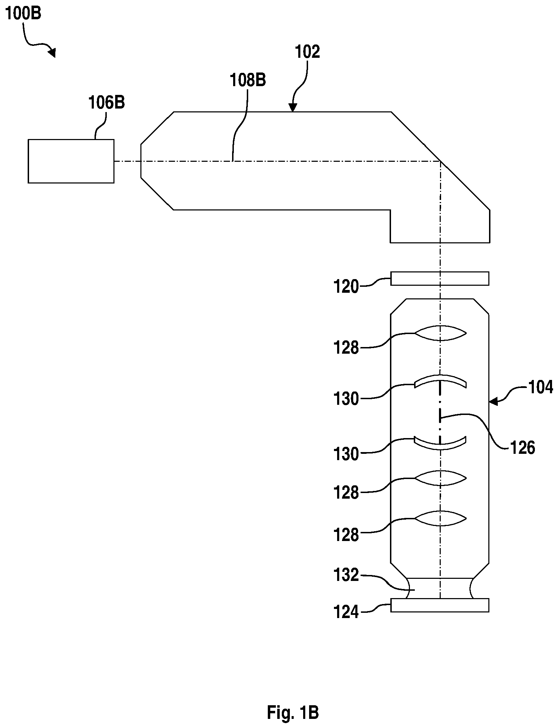

Fig. 1B zeigt eine schematische Ansicht einer DUV-Lithographieanlage 100B, welche ein Strahlformungs- und Beleuchtungssystem 102 und ein Projektionssystem 104 umfasst. Dabei steht DUV für "tiefes Ultraviolett" (Engl.: deep ultraviolet, DUV) und bezeichnet eine Wellenlänge des Arbeitslichts zwischen 30 nm und 250 nm. Das Strahlformungs- und Beleuchtungssystem 102 und das Projektionssystem 104 können - wie bereits mit Bezug zu Fig. 1A beschrieben - in einem Vakuumgehäuse angeordnet und/oder von einem Maschinenraum mit entsprechenden Antriebsvorrichtungen umgeben sein.

Die DUV-Lithographieanlage 100B weist eine DUV-Lichtquelle 106B auf. Als DUV-Lichtquelle 106B kann beispielsweise ein ArF-Excimerlaser vorgesehen sein, welcher Strahlung 108B im DUV-Bereich bei beispielsweise 193 nm emittiert.

Das in Fig. 1B dargestellte Strahlformungs- und Beleuchtungssystem 102 leitet die DUV-Strahlung 108B auf eine Photomaske 120. Die Photomaske 120 ist als transmissives optisches Element ausgebildet und kann außerhalb der Systeme 102, 104 angeordnet sein. Die Photomaske 120 weist eine Struktur auf, welche mittels des Projektionssystems 104 verkleinert auf einen Wafer 124 oder dergleichen abgebildet wird.

Das Projektionssystem 104 weist mehrere Linsen 128 und/oder Spiegel 130 zur Abbildung der Photomaske 120 auf den Wafer 124 auf. Dabei können einzelne Linsen 128 und/oder Spiegel 130 des Projektionssystems 104 symmetrisch zu einer optischen Achse 126 des Projektionssystems 104 angeordnet sein. Es sollte beachtet werden, dass die Anzahl der Linsen 128 und Spiegel 130 der DUV-Lithographieanlage 100B nicht auf die dargestellte Anzahl beschränkt ist. Es können auch mehr oder weniger Linsen 128 und/oder Spiegel 130 vorgesehen sein. Des Weiteren sind die Spiegel 130 in der Regel an ihrer Vorderseite zur Strahlformung gekrümmt.

Ein Luftspalt zwischen der letzten Linse 128 und dem Wafer 124 kann durch ein flüssiges Medium 132 ersetzt sein, welches einen Brechungsindex > 1 aufweist. Das flüssige Medium 132 kann beispielsweise hochreines Wasser sein. Ein solcher Aufbau wird auch als Immersionslithographie bezeichnet und weist eine erhöhte photolithographische Auflösung auf. Das Medium 132 kann auch als Immersionsflüssigkeit bezeichnet werden.

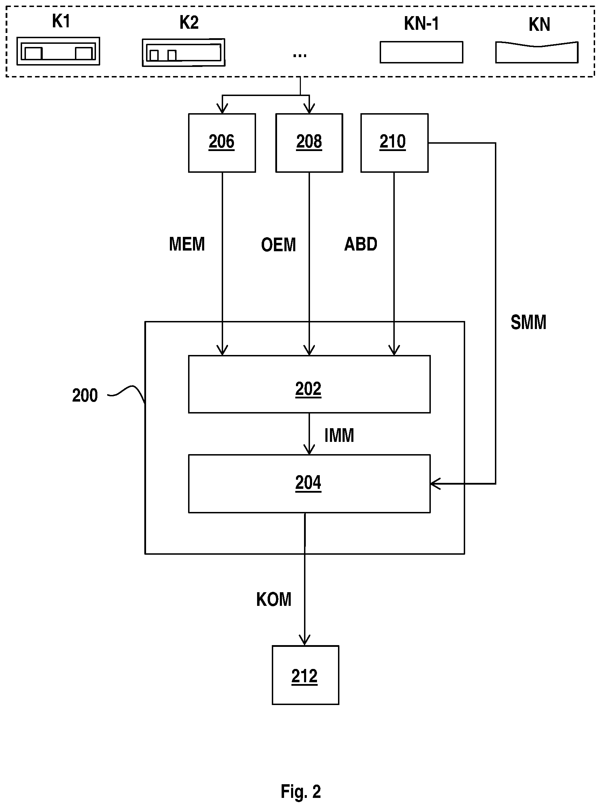

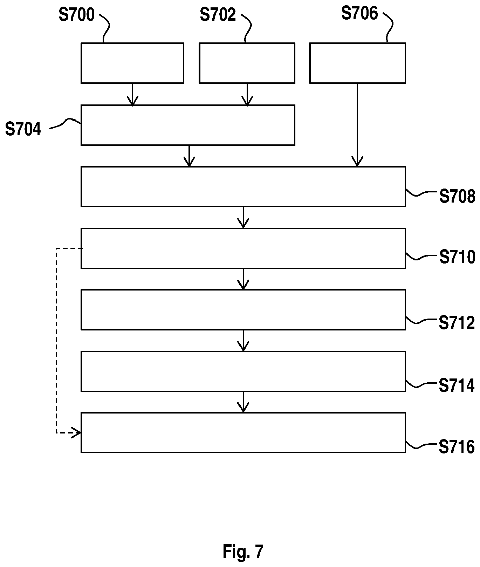

Fig. 2 zeigt eine Datenverarbeitungsvorrichtung 200 zur Verwendung in einem Verfahren zur Montage und Betrieb eines Projektionssystems bzw. -objektivs 104 (insbesondere gemäß den Figs. 1A oder 1B) oder eines sonstigen optischen Systems. Ein Flussdiagramm des Verfahrens ist in Fig. 7 gezeigt.

Die Datenverarbeitungsvorrichtung 200 ist beispielsweise als Rechnereinrichtung samt Mikroprozessor und zugeordneten Speichermitteln, wie etwa RAM, ROM etc., ausgebildet. Die Datenverarbeitungsvorrichtung 200 weist eine Virtualisier-Einheit 202 und eine Ermittler-Einheit 204 auf. Die Einheiten 202, 204 können hardwaretechnisch und/oder softwaretechnisch, d. h., in Form von Programmcode, verwirklicht sein.

Der Virtualisier-Einheit 202 werden mechanische Messdaten MEM und optional optische Messdaten OEM bereitgestellt. Daneben könnten ihr auch weitere Messdaten, wie thermische Messdaten, bereitgestellt werden.

Die mechanischen Messdaten beschreiben zumindest eine Geometrie eines jeweiligen Einzelteils K1 bis KN. Die Einzelteile K1 bis KN sind beispielhaft in Fig. 2 in einem noch nicht montierten Zustand gezeigt und werden in einem später noch näher beschriebenen Montageschritt zu dem Projektionsobjektiv 104 (siehe Figs. 1A, 1B, 3 und 4) zusammengebaut. Bei den Einzelteilen K1 bis KN kann es sich um einstückige Teile oder Baugruppen (zusammengesetzt aus mehreren jeweils einstückigen, miteinander verbundenen Teilen) handeln.

Die optischen Messdaten OEM beschreiben optische Eigenschaften ein oder mehrerer der Einzelteile K1 bis KN. Hier sind als Beispiele zu nennen: eine Lage der optischen Achse oder optischen Fläche, Reflektivität (ggf. ortsaufgelöste), Transmission (ggf. auch ortsaufgelöst).

Die mechanischen Messdaten MEM können insbesondere von einer Messeinrichtung 206, wie etwa einer Koordinatenmessmaschine (KMG), erfasst (S700 in Fig. 7) und bereitgestellt werden, welche hierzu die Einzelteile K1 bis KN (in der Realität) mechanisch vermisst. Die optischen Messdaten OEM können ebenfalls von einer Messeinrichtung 208, wie etwa einem Interferometer, erfasst (Schritt S702) und bereitgestellt werden, welche die Einzelteile K1 bis KN (in der Realität) optisch vermisst.

Die Virtualisier-Einheit 202 erzeugt aus den bereitgestellten Messdaten MEM, OEM virtualisierte Einzelteile K1 - KN (S704 in Fig. 7). Hierunter ist eine mathematische, insbesondere geometrische Beschreibung der (realen) Einzelteile K1 - KN, beispielsweise in Form von Matrizen, gemeint, die in einem Datenspeicher abgelegt wird.

Weiterhin werden der Virtualisier-Einheit 202 Aufbaudaten ABD bereitgestellt. Die Aufbaudaten ABD beschreiben zumindest geometrische und ggf. mechanische Verbindungen, Schnittstellen und Kontaktflächen zwischen den virtualisierten Einzelteilen K1 bis KN in dem noch zu erstellenden virtuellen Ist-Montage-Modell IMM. Die geometrischen Verbindungen bzw. geometrischen Schnittstellen bilden dabei reale Verbindungen bzw. Schnittstellen, wie etwa Befestigungen zwischen den zu montierten Einzelteilen K1 - KN nach.

Die Aufbaudaten ABD können aus einem CAD (Computer Aided Design)-Programm und/oder aus einem Optikdesignprogramm bereitgestellt werden (S706 in Fig. 7). Diese Software kann beispielsweise auf einer Rechnereinrichtung 210 betrieben werden.

Die Virtualisier-Einheit 202 erzeugt aus den virtualisierten Einzelteilen K1 bis KN sowie den Aufbaudaten ABD ein (virtuelles) Ist-Montage-Modell IMM (S708 in Fig. 7). In dem Ist-Montage-Modell IMM sind die Einzelteile K1 bis KN virtuell aneinander montiert, wobei die Beziehungen, insbesondere geometrische Anordnung, der Einzelteile K1 bis KN zueinander durch die Aufbaudaten ABD, insbesondere mittels der dort beschriebenen Kontaktflächen- und Schnittstelleninformationen, definiert sind.

Das Ist-Montage-Modell IMM kann auf unterschiedliche Art und Weise erzeugt werden, wobei sich dann die im weiteren ermittelte Korrekturmaßnahme KOM nach dem entsprechenden Modell richten. Grundsätzlich wird die Korrekturmaßnahme KOM aus dem Ist-Montage-Modell IMM und einem Soll-Montage-Modell SMM ermittelt, insbesondere durch Vergleich der beiden Modelle IMM, SMM.

Das Soll-Montage-Modell SMM beschreibt virtuelle Soll-Positionen eines oder mehrerer der virtualisierten Einzelteile K1 - KN in dem virtuell montierten Zustand. Dem Soll-Montage-Modell SMM geht dabei von idealisierten Einzelteilen K1 - KN aus, also solchen, die beispielsweise exakt dem CAD-Modell entsprechen. Die idealisierten Einzelteile K1 bis KN sind dabei mittels der Aufbaudaten ABD miteinander, insbesondere geometrisch, verknüpft. Das Soll-Montage-Modell SMM kann ebenfalls aus dem CAD (Computer Aided Design)-Programm und/oder aus einem Optikdesignprogramm bereitgestellt werden, d. h. beispielsweise mithilfe der Rechnereinrichtung 210. Die Korrekturmaßnahmen KOM können insbesondere an eine CNC (Engl.: computer numeric controlled)-Fräse 212 in Form von Daten bereitgestellt werden. Die CNC-Fräse 212 fräst in Abhängigkeit der Korrekturmaßnahme bzw. der entsprechenden Daten automatisiert geeignete Abstandshalter 304 (siehe Erläuterungen nachstehend) oder sonstige Ausgleichselemente.

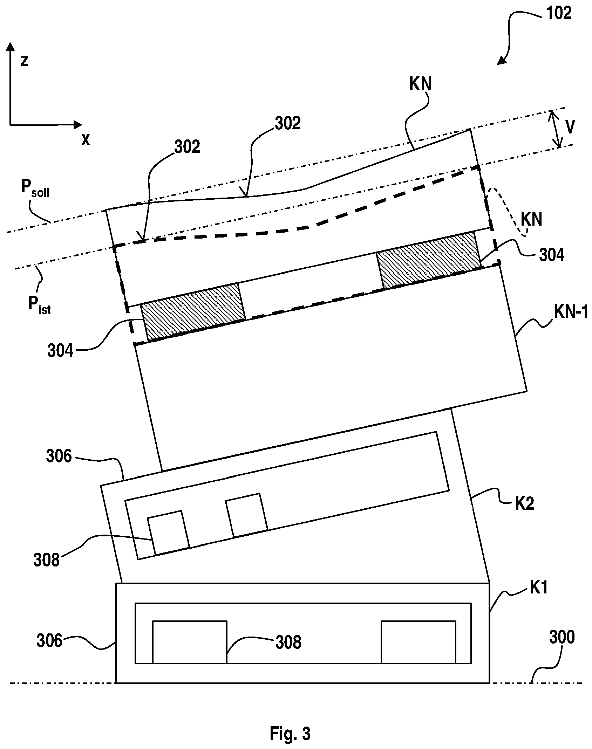

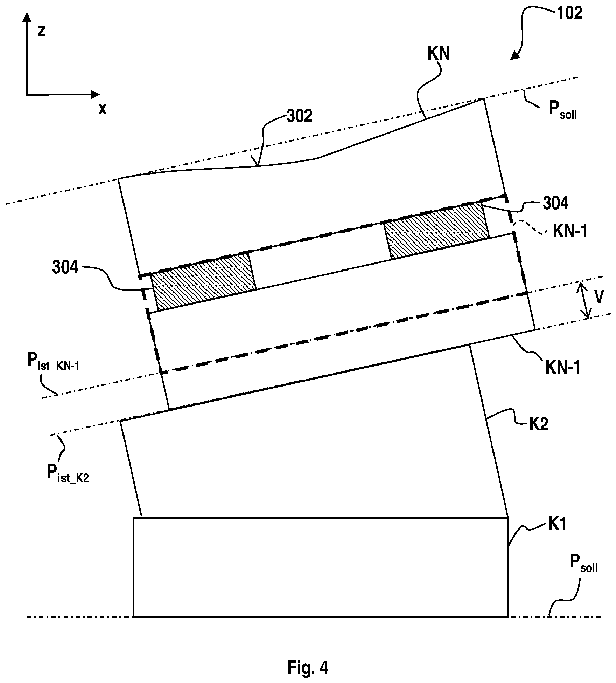

Nachfolgend wird zunächst ein Kontakt-Montage-Modell im Zusammenhang mit Fig. 3 erläutert, danach ein Sollpunkt-Montage-Modell bezugnehmend auf Fig. 4.

Gemäß dem Kontakt-Montage-Modell werden die virtualisierten Einzelteile K1 bis KN geometrisch aneinandergereiht, im Ausführungsbeispiel aufeinandergestapelt. Dabei wird beispielsweise für das Einzelteile K1 eine Basis 300 gewählt. Die folgenden Einzelteile K2 bis KN werden unter Berücksichtigung der Aufbaudaten ABD aufeinandergestapelt, also K2 auf K1, K3 auf K2 ... KN auf KN -1.

Das Einzelteil KN wird beispielsweise so gewählt, dass es sich dabei um ein solches Bauteil handelt, welches eine sogenannte Funktionsfläche aufweist. Damit sind für die Funktion der Lithographieanlage kritische Flächen gemeint, wie etwa optische Flächen oder Endstopps, d. h. die Maximalbewegung optischer Elemente begrenzende Anschläge. Das Einzelteil KN ist also insbesondere ein optisches Element, beispielsweise ein Spiegel, eine Linse, ein optisches Gitter und oder eine Lambda-Platte. Im Ausführungsbeispiel handelt es sich bei dem Einzelteil KN um einen Spiegel mit einer optisch wirksamen Fläche 302 (englisch: optical footprint).

Im Wege des Aufeinanderstapelns der Einzelteile K1 bis KN ergibt sich nun, dass das Einzelteil KN bzw. dessen Funktionsfläche (optisch wirksame Fläche 302) an einer Ist-Position Pᵢₛₜ angeordnet ist. In dieser Position ist das Einzelteil KN in Fig. 3 in gestrichelte Linie dargestellt.

Die Ermittler-Einheit 204 (siehe Fig. 2) vergleicht die Ist-Position Pᵢₛₜ mit einer Soll-Position Pₛₒₗₗ aus dem Soll-Montage-Modell SMM. Fig. 3 zeigt die Soll-Position Pₛₒₗₗ des Einzelteils KN in durchgezogene Linie. Vorliegend ergibt sich eine Abweichung von Pᵢₛₜ von Pₛₒₗₗ in Form eines Versatzes bzw. Spalts V in x-Richtung (also beispielsweise in der Ebene der Haupterstreckungsebene der optisch wirksamen Fläche 302) und z-Richtung, beispielsweise der Hochrichtung, also insbesondere senkrecht zur Haupterstreckungsebene der optisch wirksamen Fläche 302. Entsprechend ermittelt die Ermittler-Einheit 204 in einem Schritt S710 (Fig. 7) als Korrekturmaßnahme das Einsetzen von einem oder mehreren Abstandshaltern 304, welche als Zwischenstücke, Unterlegscheiben etc., insbesondere aus Metall und/oder Keramik, ausgebildet sein können.

Die Abstandshalter 304 werden vorzugsweise zwischen dem Einzelteil KN und dem darunterliegenden Einzelteil KN-1 eingesetzt. N beträgt dabei vorzugsweise größer 5 oder größer 10. Weiter alternativ kann die Korrekturmaßnahme an dem Einzelteil KN selbst vorgenommen werden, beispielsweise durch entsprechenden Materialabtrag an diesem.

Weiter bevorzugt ist das Einzelteil KN-1 eine mechatronische Komponente, insbesondere ein Aktuator, und/oder ein Lager. Gerade Aktuatoren weisen den Vorteil auf, dass diese derart eingestellt werden können, dass sie die Korrekturmaßnahme bereitstellen. Zum Beispiel kann im Fall des Ausführungsbeispiels nach Fig. 3 ein Aktuator KN-1 im Hinblick auf seinen Arbeitsbereich oder Arbeitspunkt so eingestellt werden, dass er den Versatz bzw. Spalt V ausgleicht. Dabei ist allerdings der (maximal) zur Verfügung stehende Stellweg des Aktuators zu berücksichtigen. In diesem Fall (wenn der Stellweg nicht ausreicht) werden also die Abstandshalter 304 nicht benötigt (was aber eher die Ausnahme sein dürfte). Vielmehr wird im Betrieb (Schritt S716 in Fig. 7) der Lithographieanlage (100A, 100B) der Aktuator KN-1 entsprechend angesteuert. In diesem Fall entfallen ggf. die Schritte S712 und S714, wie in Fig. 7 durch die gestrichelte Verbindungslinie angedeutet; die Montage des Projektionsobjektivs 104 findet ohne Anwendung von Korrekturmaßnahmen statt.

Gleiches gilt auch beispielsweise für ein Lager KN-1. Lager können beispielsweise Schraubmittel aufweisen, mithilfe derer sie einfach einstellbar sind. Entsprechend kann auch bei Befestigungsmitteln, wie etwa einer Verschraubung, vorgegangen werden. Beispielsweise wird eine Schraube mit einem geringeren Drehmoment angezogen, um den Versatz bzw. Spalt V auszugleichen. Weiter alternativ kann ein Sensor die Korrekturmaßnahme überwachen oder verifizieren.

Die vorstehend beschriebenen, ermittelten Korrekturmaßnahmen können optional in dem virtuellen Ist-Montage-Modell IMM überprüft werden. Dazu wird das Ist-Montage-Modell IMM erneut - unter Anwendung der ermittelten Korrekturmaßnahme - erzeugt und Schritt S710 wiederholt.

Anschließend wird das Projektionsobjektiv 104 aus den Einzelteilen K1 bis KN montiert (S712 in Fig. 7), wobei die ermittelten Korrekturmaßnahmen angewendet werden. Insbesondere werden diese bei der Montage des Projektionsobjektivs 104 umgesetzt, also die vorstehend beschriebenen Abstandshalter 304 gefertigt und in den Spalt V (Fig. 3) beim Zusammenbau der Einzelteile K1-KN eingesetzt. Alternativ oder zusätzlich werden diese im Betrieb beispielsweise der Lithographieanlage 100A, 100B mit dem Projektionsobjektiv 104 angewendet, wie vorstehend etwa für den Aktuator erläutert. In einem optionalen Schritt S714 wird das montierte Projektionsobjektiv 104 (real) vermessen, wobei die ermittelten Montagemessdaten zur Ermittlung weiterer Korrekturmaßnahmen, beispielsweise Einsetzen von Abstandshaltern, verwendet werden. Dies kann insbesondere durch einen Vergleich der Montagemessdaten mit dem Soll-Montage-Modell SMM erfolgen.

Weiterhin ist in Fig. 3 illustriert, dass einzelne oder sämtliche der Einzelteile K1-KN als Baugruppen ausgebildet sein können. Beispielsweise umfassen die Einzelteile K1 und K2 jeweils einen Tragrahmen 306 (Engl.: Force Frame), an welchem beispielsweise ein oder mehrere optische Elemente 308, beispielsweise Spiegel oder Linsen, befestigt sind.

Anhand von Fig. 4 wird nachstehend das bereits erwähnte Soll-Punkt-Montage-Modell erläutert. Bei diesem werden die virtualisierten Einzelteile K1 und KN an ihren Soll-Positionen Pₛₒₗₗ aus dem Soll-Montage-Modell SMM fixiert. Hiernach werden die Einzelteile K2, K3 (nicht dargestellt) usw. auf das Einzelteil K1 gestapelt, und die Einzelteile KN-X...KN-1 (nicht dargestellt) unter das Einzelteil KN gestapelt. X ist dabei eine aus dem Design zu bestimmende Zahl. Damit ergeben sich im Ausführungsbeispiel Ist-Positionen P_{ist_KN-1} (gestrichelt in Fig. 4 dargestellt) für das Einzelteil KN -1 sowie P_{ist_K2} für das Einzelteil K2. Die Ermittler-Einheit 204 ermittelt nun den Versatz bzw. Spalt V zwischen den Ist-Positionen P_{ist_KN-1} und P_{ist_K2} und bestimmt als Korrekturmaßnahme das Einfügen der Abstandshalter 304 zwischen die Einzelteile KN und KN -1, sodass der Versatz bzw. Spalt V aufgehoben wird bzw. die Einzelteile KN-1 und K2 in der durch die Aufbaudaten ABD definierten Anordnung zueinanderstehen. Die sich damit ergebende neue Position des Einzelteils KN -1 ist in Fig. 4 in durchgezogene Linie dargestellt.

Im Übrigen gelten die für Fig. 3 beschriebenen Merkmale entsprechend für Fig. 4.

In den Ausführungsbeispielen nach den Figuren 3 und 4 betrifft die Korrekturmaßnahmen lediglich zwei Freiheitsgrade, nämlich die translatorischen Richtungen x und z. Selbstverständlich kann die Korrekturmaßnahme jeden der sechs Freiheitsgrade (drei rotatorische und drei translatorische), und auch mehrere dieser Freiheitsgrade gleichzeitig betreffen.

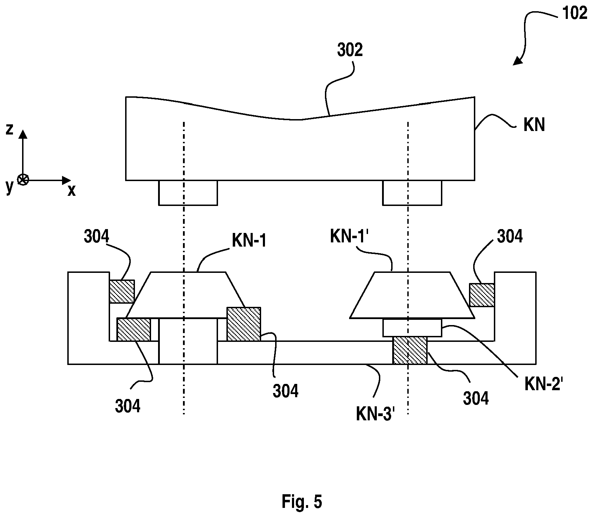

So zeigt beispielsweise Fig. 5 das Einsetzen von Abstandshaltern 304 zur Korrektur eines jeweiligen Versatzes bzw. Spalts V in x, y und z-Richtung. Linksseitig ist dabei eine Korrekturmaßnahme gezeigt, die die Korrektur in drei Raumrichtungen an einem Einzelteil KN-1 betrifft. Dagegen werden rechtsseitig Korrekturmaßnahmen betreffend unterschiedliche Raumrichtungen x, z an zumindest zwei unterschiedlichen Einzelteilen vorgenommen, nämlich dem Aktuator KN-1' (in x-Richtung) und dem Befestigungsmittel KN-2' (in z-Richtung), welches den Aktuator KN-1' an einem Träger KN-3' fixiert. Nach der Montage der Abstandshalter 304 wird das optische Element KN mit den Aktuatoren KN-1, KN-1' zu dem Projektionsobjektiv 104 zusammengefügt. Die optische Fläche 302 befindet sich dann an ihrer gewünschten Soll-Position Pₛₒₗₗ.

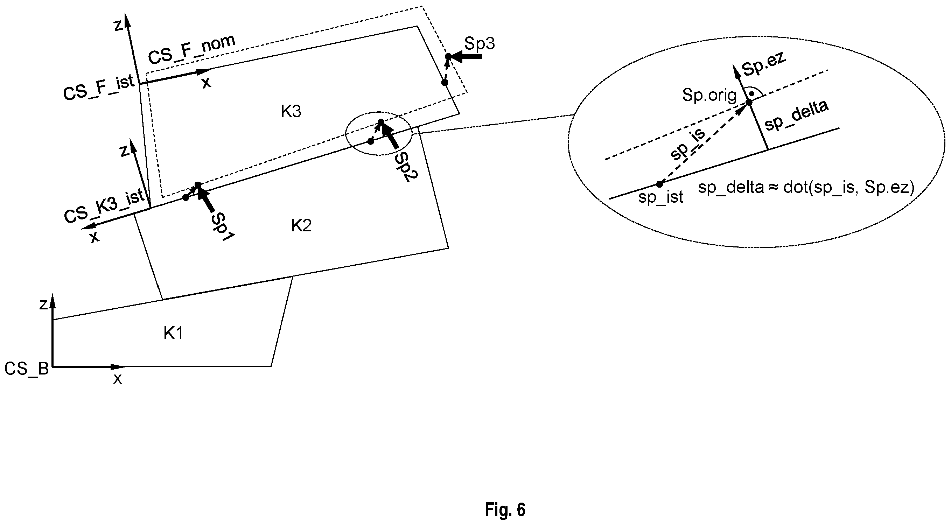

Die vorstehend beschriebenen Ist-Montage-Modelle IMM können mithilfe homogener Koordinaten und/oder Eulerwinkeln ermittelt werden, wie nachstehend in Fig. 6 illustriert.

Die Komponenten K1, K2 (entspricht KN-1) und K3 (entspricht KN-1) sind aufgrund von Fertigungstoleranzen von jeweiligen Soll-Positionen (im Weiteren auch "Design" oder "Soll-Lage") abweichend angeordnet.

Damit stellt sich die Aufgabe zu ermitteln, welche Dicken die Stellelemente Sp1, Sp2 und Sp3 (entsprechen insbesondere den Abstandshaltern 304) aufweisen sollen, damit die Funktionsfläche CS_F_ist bezüglich der Basis CS_B auf Soll-Position CS_F_soll steht, und zwar genauer als die Summe der Fertigungstoleranzen, meist sogar genauer als jede einzelne Fertigungstoleranz.

Das Koordinatensystem CS_K repräsentiert den Körper K (Virtualisierung) und ist definiert durch: CS.orig = Ursprung, CS.ex = X-Achse, CS.ey = Y-Achse und CS.ez = Z-Achse, wobei (CS_K)^B die Koordinaten von CS_K im CS_B meint.

Hierzu nachfolgendes Rechenbeispiel:
Soll-Positionen gegeben in CS_B:
(CS_F_soll)^B = [95, 200, 305] mm, Ry = -14°

| | | |
|---|---|---|
| CS_F_soll= | name: | 'CS_F' |
| | base: | 'CS_Base' |
| | orig: | [95 200 305] |
| | ex: | [0.9703 0 0.2419] |
| | ey: | [0 10 ] |
| | ez: | [-0.2419 0 0.9703] |

3 Spacer-Aufpunkte und -Wirkrichtungen:

| | | | | | | | | |
|---|---|---|---|---|---|---|---|---|
| Sp1= | name: | 'Spc1' | Sp2= | name: | 'Spc2' | Sp3= | name: | 'Spc3' |
| | base: | 'CS_Base' | | base: | 'CS_Base' | | base: | 'CS_Base' |
| | orig: | [150 300 190] | | orig: | [340 300 250] | | orig: | [410 300 320] |
| | ez: | [-1 0 2]/sqrt (5) | | ez: | [-1 0 2]/sqrt (5) | | ex: | [-1 0 0] |

CS_K3 sei gemessen in CS_B:
(CS_K3_ist)^B = [103 210 167], Ry = -17°, Rz = 182°

| | | |
|---|---|---|
| CS_K3_ist= | name: | 'CS_K3' |
| | base: | 'CS_Base' |
| | orig: | [103 210 167] |
| | ex: | [-0.9557 -0.0298 -0.2928] |
| | ey: | [0.0334 -0.994 -0.0072] |
| | ez: | [-0.2924 -0.0167 0.9562] |

CS_F sei gemessen in CS_K3_ist:
(CS_F_ist)^K3 = [-25 0 126] mm, Ry = -5°, Rz = 179°

| | | |
|---|---|---|
| CS_F_ist_K3= | name: | 'CS_F' |
| | base: | 'CS_K3' |
| | orig: | [-25 0 126] |
| | ex: | [-0.9960 0.0175 -0.0871] |
| | ey: | [-0.0174 -0.9998 -0.0015] |
| | ez: | [-0.0872 0 0.9962] |

Berechnung der Ist-Lage bzw. Ist-Position von CS_F in CS_B durch Koordinatentransformation von CS_K3 nach CS_B, z.B. in homogenen Koordinaten:
(CS_F_ist)^B = K3_2_B * (CS_F_ist)^K3

| | | | |
|---|---|---|---|
| K3_2_B = | | | |
| -0.9557 | 0.0334 | -0.2924 | 103.0000 |
| -0.0298 | -0.9994 | -0.0167 | 210.000 |
| -0.2928 | -0.0072 | 0.9562 | 167.000 |
| 0 | 0 | 0 | 1.000 |

mit der 4x4-Transformationsmatrix K3_2_B

| | | |
|---|---|---|
| CS_F_ist= | name: | 'CS_F' |
| | base: | 'CS_Base' |
| | orig: | [90.0542 208.5420 294.7950] |
| | ex: | [0.9780 0.0137 0.2082] |
| | ey: | [-0.0163 0.9998 0.0109] |
| | ez: | [-0.2080 -0.0140 0.9780] |

Ablage CS_F_Ist von CS_F_Soll in CS_B-Koordinaten (IS_abs) und CS_F_Soll-Koordinaten (IS_rel), sowie Bewertung der Ist-Lage bzw. Ist-Position (Vergleich mit Spezifikation Tol_rel):
Lage CS_F bzgl CS_Base:

| [mm,mrad] | Tx | Ty | Tz | Rx | Ry | Rz |
|---|---|---|---|---|---|---|
| Soll: | 95.000 | 200.000 | 305.000 | -0.000 | -244.346 | -0.000 |
| Ist: | 90.054 | 208.642 | 294.795 | 14.344 | -209.491 | 16.674 |
| I-s_abs: | -4.946 | 8.642 | -10.205 | 14.344 | 34.855 | 16.674 |
| I-S_rel: | -7.268 | 8.642 | -8.705 | 14.039 | 34.830 | 13.202 |
| Tol_rel: | 2.000 | 2.000 | 1000 | 5.000 | 5.000 | 2.000 |

Stellweg-Berechnung in CS_B, wobei Sp.ez der Einheitsvektor in der Wirkrichtung des Stellelements (bspw. ist die Wirkrichtung die Dicke, in welcher es die Verschiebung von K3 in die Soll-Position bewirken soll), Sp.orig die Soll-Position von K3 in dem Aufpunkt (K3-seitige Auflage des Stellelements), und sp_ist die Ist-Position von K3 in dem Aufpunkt ist:
sp_delta = dot(sp_is, Sp.ez)
mit sp_is = Sp.orig - sp_ist
= Spacerpunkt-Verschiebung von Ist nach Soll

| Änderung | [mm] |
|---|---|
| Sp1 | 5.04 |
| Sp2 | 11.83 |
| Sp3 | -6.29 |

Obwohl die vorliegende Erfindung anhand von Ausführungsbeispielen beschrieben wurde, ist sie vielfältig modifizierbar.

### BEZUGSZEICHENLISTE

- 100A: EUV-Lithographieanlage
- 100B: DUV-Lithographieanlage
- 104: Strahlformungs- und Beleuchtungssystem
- 104: Projektionssystem
- 106A: EUV-Lichtquelle
- 106B: DUV-Lichtquelle
- 108A: EUV-Strahlung
- 108B: DUV-Strahlung
- 110: Spiegel
- 112: Spiegel
- 114: Spiegel
- 116: Spiegel
- 118: Spiegel
- 120: Photomaske
- 122: Spiegel
- 124: Wafer
- 126: optische Achse
- 128: Linse
- 130: Spiegel
- 132: Medium
- 200: Datenverarbeitungsvorrichtung
- 202: Virtualisier-Einheit
- 204: Ermittler-Einheit
- 206: Messeinrichtung
- 208: Messeinrichtung
- 210: Rechnereinrichtung
- 212: CNC-Fräse
- 300: Basis
- 302: optisch wirksamen Fläche
- 304: Abstandshalter
- 306: Tragrahmen
- 308: optisches Element
- ABD: Aufbaudaten
- IMM: Ist-Montage-Modell
- KOM: Korrekturmaßnahme
- K1 - KN: Einzelteile
- Pₛₒₗₗ: Soll-Position
- Pᵢₛₜ: Ist-Position
- P_{ist_KN-1}: Ist-Position
- P_{ist_K2}: Ist-Position
- MEM: mechanische Messdaten
- M1: Spiegel
- M2: Spiegel
- M3: Spiegel
- M4: Spiegel
- M5: Spiegel
- M6: Spiegel
- OEM: optische Messdaten
- SMM: Soll-Montage-Modell
- S700-S716: Verfahrensschritte
- V: Spalt

## Patentansprüche

1. Verfahren zur Montage eines optischen Systems (104), insbesondere Lithographieanlage (100A, 100B), mit den Schritten:
a) Vermessen (S700, S702) von Einzelteilen K1 - KN des optischen Systems (104) zur Bereitstellung von Messdaten (MEM, OEM), mit N > 1,
b) Virtualisieren (S704) der Einzelteile K1 - KN mithilfe der bereitgestellten Messdaten (MEM, OEM) und Erzeugen (708) eines Ist-Montage-Modells (IMM) aus den virtualisierten Einzelteilen K1 - KN durch geometrisches Aneinanderreihen mehrerer der virtualisierten Einzelteile K1 - KN, wobei das Ist-Montagemodell (IMM) virtuelle Ist-Positionen (Pᵢₛₜ, P_{ist_KN-1}, P_{ist_K2}) der virtualisierten Einzelteile K1 - KN in einem virtuell montierten Zustand enthält,
c) Ermitteln (S710) einer Korrekturmaßnahme in Abhängigkeit des Ist-Montage-Modells (IMM) und eines Soll-Montage-Modells (SMM), wobei das Soll-Montagemodell (SMM) virtuelle Soll-Positionen (Pₛₒₗₗ) eines oder mehrerer der virtualisierten Einzelteile K1 - KN in dem virtuell montierten Zustand enthält, und
d) Montieren (S712) der Einzelteile K1 - KN zu dem optischen System (104) unter Anwendung der Korrekturmaßnahme.

2. Verfahren nach Anspruch 1, weiterhin aufweisend:
Erzeugen des Ist-Montage-Modell (IMM) durch geometrisches Aneinanderreihen der virtualisierten Einzelteile K1 - KN, und
Ermitteln der Korrekturmaßnahme in Schritt c) in Abhängigkeit eines Vergleichs der virtuellen Ist-Position (Pᵢₛₜ) des virtualisierten Einzelteils KN mit der virtuellen Soll-Position (Pₛₒₗₗ) des virtualisierten Einzelteils KN.

3. Verfahren nach Anspruch 1, weiterhin aufweisend:
Erzeugen des Ist-Montage-Modells (IMM) durch Fixieren der virtualisierten Einzelteile K1 und KN an ihren Soll-Positionen (Pₛₒₗₗ) aus dem Soll-Montage-Modell (SMM),
Geometrisches Aneinanderreihen der virtualisierten Einzelteile K2 - KN-1 an K1 und/oder KN, und
Ermitteln der Korrekturmaßnahme in Schritt c) in Abhängigkeit von virtuellen Ist-Positionen (P_{ist_KN-1}, P_{ist_K2}) von zumindest zwei virtualisierten Einzelteilen K2 - KN-1.

4. Verfahren nach einem der Ansprüche 1 - 3, wobei die Korrekturmaßnahme in Schritt d) auf das Einzelteil KN-1 oder auf einen Bereich, insbesondere Spalt (V), zwischen den Einzelteilen KN-1 und KN angewendet wird.

5. Verfahren nach einem der Ansprüche 1 - 4,
wobei das Einzelteil KN aufweist: ein optisches Element, insbesondere ein Spiegel, eine Linse, ein optisches Gitter und/oder eine Lambda-Platte, oder eine Blende, einen Sensor und/oder einen Endstopp, und/oder
wobei das Einzelteil KN-1 aufweist: eine mechanische Komponente, eine mechatronische Komponente, insbesondere ein Aktuator, und/oder ein Lager.

6. Verfahren nach einem der Ansprüche 1 - 5, wobei die Korrekturmaßnahme aufweist: Einfügen eines Abstandshalters (304), insbesondere zwischen zwei der Einzelteile K1 - KN, Einstellen eines Spiels eines Befestigungsmittels, das insbesondere zwei der Einzelteile K1 - KN aneinander befestigt, und/oder Einstellen eines Arbeitspunkts einer mechatronischen Komponente, insbesondere eines Aktuators als Bestandteil eines der Einzelteile K1 - KN.

7. Verfahren nach Anspruch 5 oder 6, wobei die Korrekturmaßnahme in Schritt c) ermittelt wird in Abhängigkeit eines zur Verfügung stehenden Stellwegs des Aktuators.

8. Verfahren nach einem der Ansprüche 1 - 7, wobei N > 5 oder 10 ist.

9. Verfahren nach einem der Ansprüche 1 - 8, wobei in Schritt c) ein Spalt (V) zwischen zwei der Einzelteile K1 - KN ermittelt und in Schritt d) ein Abstandshalter in den Spalt eingefügt wird.

10. Verfahren nach einem der Ansprüche 1 - 9, wobei die Korrekturmaßnahme gemäß Schritt c) zumindest einen ersten und einen zweiten Freiheitsgrad (x, y, z) betrifft.

11. Verfahren nach Anspruch 10, wobei die Korrekturmaßnahme in Schritt d) für den ersten Freiheitsgrad (x) auf ein erstes der Einzelteile K1 - KN oder zwischen einem ersten Paar Einzelteile K1 - KN und für den zweiten Freiheitsgrad (z) auf ein zweites der Einzelteile K1 - KN oder zwischen einem zweiten Paar Einzelteile K1 - KN angewendet wird.

12. Verfahren nach einem der Ansprüche 1 - 11, ferner aufweisend:
Vermessen (S714) des montierten optischen Systems (104) zur Bereitstellung von Montagemessdaten,
Ermitteln einer weiteren Korrekturmaßnahme in Abhängigkeit eines Vergleichs der Montagemessdaten und dem Soll-Montage-Modell (SMM), und
Ausrichten eines oder mehrerer der Einzelteile K1 - KN in Abhängigkeit der ermittelten weiteren Korrekturmaßnahme.

13. Verfahren zum Betrieb eines optischen Systems (104), insbesondere Lithographieanlage (100A, 100B), mit den Schritten:
a) Vermessen (S700, S702) von Einzelteilen K1 - KN des optischen Systems (104) zur Bereitstellung von Messdaten (MEM, OEM), mit N > 1,
b) Virtualisieren (S704) der Einzelteile K1 - KN mithilfe der bereitgestellten Messdaten (MEM, OEM) und Erzeugen (S708) eines Ist-Montage-Modells (IMM) aus den virtualisierten Einzelteilen K1 - KN durch geometrisches Aneinanderreihen mehrerer der virtualisierten Einzelteile K1 - KN, wobei das Ist-Montagemodell (IMM) virtuelle Ist-Positionen (Pᵢₛₜ, P_{ist_KN-1}, P_{ist_K2}) der virtualisierten Einzelteile K1 - KN in einem virtuell montierten Zustand enthält,
c) Ermitteln (S710) einer Korrekturmaßnahme in Abhängigkeit des Ist-Montage-Modells (IMM) und eines Soll-Montage-Modells (SMM), wobei das Soll-Montagemodell (SMM) virtuelle Soll-Positionen (Pₛₒₗₗ) eines oder mehrerer der virtualisierten Einzelteile K1 - KN in dem virtuell montierten Zustand enthält, und
d) Montieren (S712) der Einzelteile K1 - KN zu dem optischen System (104) und Betreiben des optischen Systems (104) unter Anwendung der Korrekturmaßnahme.

14. Datenverarbeitungsvorrichtung (200), mit:
einer Virtualisier-Einheit (202) zur Virtualisierung von Einzelteile K1 - KN eines optischen Systems (104) mithilfe von bereitgestellten Messdaten (MEM, OEM) und Erzeugung eines Ist-Montage-Modells (IMM) aus den virtualisierten Einzelteilen K1 - KN durch geometrisches Aneinanderreihen mehrerer der virtualisierten Einzelteile K1 - KN, wobei das Ist-Montagemodell (IMM) virtuelle Ist-Positionen (Pᵢₛₜ, P_{ist_KN-1}, P_{ist_K2}) der virtualisierten Einzelteile K1 - KN in einem virtuell montierten Zustand enthält, und
einer Ermittler-Einheit (204) zur Ermittlung einer Korrekturmaßnahme zur Anwendung bei einer Montage des optischen Systems (104) aus den Einzelteilten K1 - KN oder bei einem Betrieb des aus den Einzelteilten K1 - KN montierten optischen Systems (104) in Abhängigkeit des Ist-Montage-Modells (IMM) und eines Soll-Montage-Modells (SMM), wobei das Soll-Montagemodell (SMM) virtuelle Soll-Positionen (Pₛₒₗₗ) eines oder mehrerer der virtualisierten Einzelteile K1 - KN in dem virtuell montierten Zustand enthält.

15. Computerprogrammprodukt, welches auf zumindest einer programmgesteuerten Einrichtung die Durchführung der folgenden Schritte veranlasst:
Virtualisieren (S704) von Einzelteilen K1 - KN eines optischen Systems (104) mithilfe von bereitgestellten Messdaten (MEM, OEM) und Erzeugen (S708) eines Ist-Montage-Modells (IMM) aus den virtualisierten Einzelteilen K1 - KN durch geometrisches Aneinanderreihen mehrerer der virtualisierten Einzelteile K1 - KN, wobei das Ist-Montagemodell (IMM) virtuelle Ist-Positionen (Pᵢₛₜ, P_{ist_KN}-₁, P_{ist_K2}) der virtualisierten Einzelteile K1 - KN in einem virtuell montierten Zustand enthält, und
Ermitteln (S710) einer Korrekturmaßnahme zur Anwendung bei einer Montage des optischen Systems (104) aus den Einzelteilten K1 - KN oder bei einem Betrieb des aus den Einzelteilten K1 - KN montierten optischen Systems (104) in Abhängigkeit des Ist-Montage-Modells (IMM) und eines Soll-Montage-Modell (SMM), wobei das Soll-Montagemodell (SMM) virtuelle Soll-Positionen (Pₛₒₗₗ) eines oder mehrerer der virtualisierten Einzelteile K1 - KN in dem virtuell montierten Zustand enthält.

## Claims

1. Method for assembling an optical system (104), in particular a lithography apparatus (100A, 100B), including the steps of:
a) measuring (S700, S702) individual parts K1 - KN of the optical system (104) for the purposes of providing measurement data (MEM, OEM), where N >1,
b) virtualizing (S704) the individual parts K1 - KN with the aid of the provided measurement data (MEM, OEM) and generating (S708) an actual assembly model (IMM) from the virtualized individual parts K1 - KN by geometric stringing together of a plurality of the virtualized individual parts K1 - KN, the actual assembly model (IMM) containing virtual actual positions (P_{actual}, P_{actual_KN-1}, P_{actual_K2}) of the virtualized individual parts K1 - KN in a virtually assembled state,
c) determining (S710) a correction measure on the basis of the actual assembly model (IMM) and a target assembly model (SMM), the target assembly model (SMM) containing virtual target positions (P_{target}) of one or more of the virtualized individual parts K1 - KN in the virtually assembled state, and
d) assembling (S712) the individual parts K1 - KN to form the optical system (104) using the correction measure.

2. Method according to Claim 1, furthermore including:
generating the actual assembly model (IMM) by geometric stringing together of the virtualized individual parts K1 - KN, and
determining the correction measure in step c) on the basis of a comparison between the virtual actual position (P_{actual}) of the virtualized individual part KN and the virtual target position (P_{target}) of the virtualized individual part KN.

3. Method according to Claim 1, furthermore including:
generating the actual assembly model (IMM) by fixing the virtualized individual parts K1 and KN at their target positions (P_{target}) from the target assembly model (SMM),
geometrically stringing together the virtualized individual parts K2 - KN-1 with K1 and/or KN, and
determining the correction measure in step c) on the basis of virtual actual positions (P_{actual-KN-1}, P_{actual_K2}) of at least two virtualized individual parts K2 - KN-1.

4. Method according to any one of Claims 1-3, wherein the correction measure in step d) is applied to the individual part KN-1 or to a region, in particular a gap (V), between the individual parts KN-1 and KN.

5. Method according to any one of Claims 1-4,
wherein the individual part KN comprises: an optical element, in particular a mirror, a lens element, an optical grating and/or a waveplate, or a stop, a sensor and/or an end stop, and/or
wherein the individual part KN-1 comprises: a mechanical component, a mechatronic component, in particular an actuator, and/or a bearing.

6. Method according to any one of Claims 1-5, wherein the correction measure includes: inserting a spacer (304), in particular between two of the individual parts K1 - KN, adjusting a play of a fastening means which in particular fastens two of the individual parts K1 - KN to one another, and/or adjusting an operating point of a mechatronic component, in particular of an actuator as constituent part of one of the individual parts K1 - KN.

7. Method according to Claim 5 or 6, wherein the correction measure in step c) is determined on the basis of an available actuator travel of the actuator.

8. Method according to any one of Claims 1-7, wherein N > 5 or 10.

9. Method according to any one of Claims 1-8, wherein a gap (V) between two of the individual parts K1 - KN is determined in step c) and a spacer is inserted into the gap in step d).

10. Method according to any one of Claims 1-9, wherein the correction measure according to step c) relates to at least a first and a second degree of freedom (x, y, z).

11. Method according to Claim 10, wherein the correction measure is applied in step d), to a first of the individual parts K1 - KN or between a first pair of individual parts K1 - KN for the first degree of freedom (x) and to a second of the individual parts K1 - KN or between a second pair of individual parts K1 - KN for the second degree of freedom (z).

12. Method according to any one of Claims 1-11, further including:
measuring (S714) the assembled optical system (104) for the provision of assembly measurement data,
determining a further correction measure on the basis of a comparison between the assembly measurement data and the target assembly model (SMM), and
aligning one or more of the individual parts K1 - KN on the basis of the determined further correction measure.

13. Method for operating an optical system (104), in particular a lithography apparatus (100A, 100B), including the steps of:
a) measuring (S700, S702) individual parts K1 - KN of the optical system (104) for the purposes of providing measurement data (MEM, OEM), where N >1,
b) virtualizing (S704) the individual parts K1 - KN with the aid of the provided measurement data (MEM, OEM) and generating (S708) an actual assembly model (IMM) from the virtualized individual parts K1 - KN by geometric stringing together of a plurality of the virtualized individual parts K1 - KN, the actual assembly model (IMM) containing virtual actual positions (P_{actual}, P_{actual_KN-1}, P_{actual_K2}) of the virtualized individual parts K1 - KN in a virtually assembled state,
c) determining (S710) a correction measure on the basis of the actual assembly model (IMM) and a target assembly model (SMM), the target assembly model (SMM) containing virtual target positions (P_{target}) of one or more of the virtualized individual parts K1 - KN in the virtually assembled state, and
d) assembling (S712) the individual parts K1 - KN to form the optical system (104) and operating the optical system (104) using the correction measure.

14. Data processing apparatus (200), comprising:
a virtualization unit (202) for virtualizing individual parts K1 - KN of an optical system (104) with the aid of provided measurement data (MEM, OEM) and generating an actual assembly model (IMM) from the virtualized individual parts K1 - KN by geometric stringing together of a plurality of the virtualized individual parts K1 - KN, the actual assembly model (IMM) containing virtual actual positions (P_{actual}, P_{actual_KN-1}, P_{actual_K2}) of the virtualized individual parts K1 - KN in a virtually assembled state, and
a determination unit (204) for determining a correction measure for application during an assembly of the optical system (104) from the individual parts K1 - KN or during an operation of the optical system (104) assembled from the individual parts K1 - KN, on the basis of the actual assembly model (IMM) and a target assembly model (SMM), the target assembly model (SMM) containing virtual target positions (P_{target}) of one or more of the virtualized individual parts K1 - KN in the virtually assembled state.

15. Computer program product prompting the implementation of the following steps on at least one program-controlled device:
virtualizing (S704) individual parts K1 - KN of an optical system (104) with the aid of provided measurement data (MEM, OEM) and generating (S708) an actual assembly model (IMM) from the virtualized individual parts K1 - KN by geometric stringing together of a plurality of the virtualized individual parts K1 - KN, the actual assembly model (IMM) containing virtual actual positions (P_{actual}, P_{actual_KN-1}, P_{actual_K2}) of the virtualized individual parts K1 - KN in a virtually assembled state, and
determining (S710) a correction measure for application during an assembly of the optical system (104) from the individual parts K1 - KN or during an operation of the optical system (104) assembled from the individual parts K1 - KN, on the basis of the actual assembly model (IMM) and a target assembly model (SMM), the target assembly model (SMM) containing virtual target positions (P_{target}) of one or more of the virtualized individual parts K1 - KN in the virtually assembled state.

## Revendications

1. Procédé de montage d'un système optique (104), en particulier d'une installation de lithographie (100A, 100B), comprenant les étapes consistant à :
a) mesurer (S700, S702) des pièces détachées K1 à KN du système optique (104) pour fournir des données de mesure (MEM, OEM), où N > 1,
b) virtualiser (S704) les pièces détachées K1 à KN à l'aide des données de mesure (MEM, OEM) fournies et générer (708) un modèle de montage réel (IMM) à partir des pièces détachées K1 à KN virtualisées en juxtaposant géométriquement plusieurs des pièces détachées K1 à KN virtualisées, dans lequel le modèle de montage réel (IMM) contient des positions réelles virtuelles (Pᵢₛₜ, P_{ist_KN-1}, P_{ist_K2}) des pièces détachées K1 à KN virtualisées dans un état virtuellement monté,
c) déterminer (S710) une mesure de correction en fonction du modèle de montage réel (IMM) et d'un modèle de montage théorique (SMM), dans lequel le modèle de montage théorique (SMM) contient des positions théoriques virtuelles (Pₛₒₗₗ) d'une ou de plusieurs des pièces détachées K1 à KN virtualisées à l'état virtuellement monté, et
d) monter (S712) les pièces détachées K1 à KN pour former le système optique (104) en appliquant la mesure de correction.

2. Procédé selon la revendication 1, présentant en outre les étapes consistant à :
générer le modèle de montage réel (IMM) en juxtaposant géométriquement les pièces détachées K1 à KN virtualisées, et
déterminer la mesure de correction à l'étape c) en fonction d'une comparaison de la position réelle virtuelle (Pᵢₛₜ) de la pièce détachée KN virtualisée avec la position théorique virtuelle (Pₛₒₗₗ) de la pièce détachée KN virtualisée.

3. Procédé selon la revendication 1, présentant en outre les étapes consistant à :
générer le modèle de montage réel (IMM) en fixant les pièces détachées K1 et KN virtualisées au niveau de leurs positions théoriques (Pₛₒₗₗ) issues du modèle de montage théorique (SMM),
juxtaposer géométriquement les pièces détachées K2 à KN-1 virtualisées au niveau de K1 et/ou de KN, et
déterminer la mesure de correction à l'étape c) en fonction des positions réelles virtuelles (P_{ist_KN-1}, P_{ist_K2}) d'au moins deux pièces détachées K2 à KN-1 virtualisées.

4. Procédé selon l'une quelconque des revendications 1 à 3, dans lequel la mesure de correction à l'étape d) est appliquée à la pièce détachée KN-1 ou à une zone, en particulier un interstice (V), entre les pièces détachées KN-1 et KN.

5. Procédé selon l'une quelconque des revendications 1 à 4,
dans lequel la pièce détachée KN présente : un élément optique, en particulier un miroir, une lentille, un réseau optique et/ou une lame lambda, ou un diaphragme, un capteur et/ou une butée d'extrémité, et/ou
dans lequel la pièce détachée KN-1 présente : un composant mécanique, un composant mécatronique, en particulier un actionneur, et/ou un palier.

6. Procédé selon l'une quelconque des revendications 1 à 5, dans lequel la mesure de correction présente les étapes consistant à : insérer un écarteur (304), en particulier entre deux des pièces détachées K1 à KN, régler un jeu d'un moyen de fixation qui fixe en particulier deux des pièces détachées K1 à KN l'une à l'autre, et/ou régler un point de fonctionnement dynamique d'un composant mécatronique, en particulier d'un actionneur, faisant partie d'une des pièces détachées K1 à KN.

7. Procédé selon la revendication 5 ou 6, dans lequel la mesure de correction est déterminée à l'étape c) en fonction d'un parcours de réglage disponible de l'actionneur.

8. Procédé selon l'une quelconque des revendications 1 à 7, dans lequel N > 5 ou 10.

9. Procédé selon l'une quelconque des revendications 1 à 8, dans lequel à l'étape c), un interstice (V) entre deux des pièces détachées K1 à KN est déterminé, et à l'étape d) un écarteur est inséré dans l'interstice.

10. Procédé selon l'une quelconque des revendications 1 à 9, dans lequel la mesure de correction selon l'étape c) concerne au moins un premier et un deuxième degré de liberté (x, y, z).

11. Procédé selon la revendication 10, dans lequel la mesure de correction à l'étape d) est appliquée pour le premier degré de liberté (x) à une première des pièces détachées K1 à KN ou entre une première paire de pièces détachées K1 à KN et pour le deuxième degré de liberté (z) à une deuxième des pièces détachées K1 à KN ou entre une deuxième paire de pièces détachées K1 à KN.

12. Procédé selon l'une quelconque des revendications 1 à 11, présentant en outre les étapes consistant à :
mesurer (S714) le système optique monté (104) pour fournir des données de mesure de montage,
déterminer une mesure de correction supplémentaire en fonction d'une comparaison des données de mesure de montage et du modèle de montage théorique (SMM), et
aligner une ou plusieurs des pièces détachées K1 à KN en fonction de la mesure de correction supplémentaire déterminée.

13. Procédé permettant de faire fonctionner un système optique (104), en particulier une installation de lithographie (100A, 100B), comprenant les étapes consistant à :
a) mesurer (S700, S702) des pièces détachées K1 à KN du système optique (104) pour fournir des données de mesure (MEM, OEM), où N > 1,
b) virtualiser (S704) les pièces détachées K1 à KN à l'aide des données de mesure (MEM, OEM) fournies et générer (S708) un modèle de montage réel (IMM) à partir des pièces détachées K1 à KN virtualisées en juxtaposant géométriquement plusieurs des pièces détachées K1 à KN virtualisées, dans lequel le modèle de montage réel (IMM) contient des positions réelles virtuelles (Pᵢₛₜ, P_{ist_KN-1}, P_{ist_K2}) des pièces détachées K1 à KN virtualisées dans un état virtuellement monté,
c) déterminer (S710) une mesure de correction en fonction du modèle de montage réel (IMM) et d'un modèle de montage théorique (SMM), dans lequel le modèle de montage théorique (SMM) contient des positions théoriques virtuelles (Pₛₒₗₗ) d'une ou de plusieurs des pièces détachées K1 à KN virtualisées à l'état virtuellement monté, et
d) monter (S712) les pièces détachées K1 à KN pour former le système optique (104), et faire fonctionner le système optique (104) en appliquant la mesure de correction.

14. Dispositif de traitement de données (200), comprenant :
une unité de virtualisation (202) pour virtualiser des pièces détachées K1 à KN d'un système optique (104) à l'aide de données de mesure (MEM, OEM) fournies, et pour générer un modèle de montage réel (IMM) à partir des pièces détachées K1 à KN virtualisées en juxtaposant géométriquement plusieurs des pièces détachées K1 à KN virtualisées, dans lequel le modèle de montage réel (IMM) contient des positions réelles virtuelles (Pᵢₛₜ, P_{ist_KN-1}, P_{ist_K2}) des pièces détachées K1 à KN virtualisées dans un état virtuellement monté, et
une unité de détermination (204) pour déterminer une mesure de correction à appliquer lors d'un montage du système optique (104) à partir des pièces détachées K1 à KN ou lors d'un fonctionnement du système optique (104) monté à partir des pièces détachées K1 à KN en fonction du modèle de montage réel (IMM) et d'un modèle de montage théorique (SMM), dans lequel le modèle de montage théorique (SMM) contient des positions théoriques virtuelles (Pₛₒₗₗ) d'une ou de plusieurs des pièces détachées K1 à KN virtualisées à l'état virtuellement monté.

15. Produit de programme informatique qui provoque sur au moins un équipement commandé par programme l'exécution des étapes suivantes consistant à :
virtualiser (S704) des pièces détachées K1 à KN d'un système optique (104) à l'aide de données de mesure (MEM, OEM) fournies, et générer (S708) un modèle de montage réel (IMM) à partir des pièces détachées K1 à KN virtualisées en juxtaposant géométriquement plusieurs des pièces détachées K1 à KN virtualisées, dans lequel le modèle de montage réel (IMM) contient des positions réelles virtuelles (Pᵢₛₜ, P_{ist_KN-1}, P_{ist_K2}) des pièces détachées K1 à KN virtualisées dans un état virtuellement monté, et
déterminer (S710) une mesure de correction à appliquer lors d'un montage du système optique (104) à partir des pièces détachées K1 à KN ou lors d'un fonctionnement du système optique (104) monté à partir des pièces détachées K1 à KN en fonction du modèle de montage réel (IMM) et d'un modèle de montage théorique (SMM), dans lequel le modèle de montage théorique (SMM) contient des positions théoriques virtuelles (Pₛₒₗₗ) d'une ou de plusieurs des pièces détachées K1 à KN virtualisées à l'état virtuellement monté.
